# FASCICULE DE BREVET EUROPEEN

(11) **EP 2 534 678 B1**
(45) Date de publication et mention de la délivrance du brevet: **11.02.2015**
(21) Numéro de dépôt: 10807619.1
(22) Date de dépôt: 17.12.2010
(51) Int. Cl.: H01L 21/768, H01L 23/532

(54) **STRUCTURE D'INTERCONNEXION A BASE DE NANOTUBES DE CARBONE REDIRIGES**
VERBINDUNGSSTRUKTUR AUS UMGELEITETEN KOHLENSTOFFNANORÖHRCHEN
INTERCONNECTION STRUCTURE MADE OF REDIRECTED CARBON NANOTUBES

(30) Priorité: 11.02.2010 FR 1050986
(43) Date de publication de la demande: 19.12.2012
(73) Titulaire: Commissariat à l'Énergie Atomique et aux Énergies Alternatives, 75015 Paris (FR)
(72) Inventeur: DIJON, Jean, F-38800 Champagnier (FR)
(74) Mandataire: Vuillermoz, Bruno
(86) Numéro de dépôt international: PCT/FR2010/052792
(87) Numéro de publication internationale: WO 2011/098679

(56) Documents cités:
- CN-A- 101 562 148
- US-A1- 2006 212 974
- US-A1- 2008 042 287
- US-A1- 2009 294 966
- Hayamizu et al.: "Integrated three-dimensional microelectromechanical devices from processable carbon nanotube wafers", Nature Publishing Group , vol. 3 4 mai 2008 (2008-05-04), pages 289-294, XP002599670, Extrait de l'Internet: URL:http://www.nature.com/nnano/journal/v3 /n5/full/nnano.2008.98.html [extrait le 2008-05-04] cité dans la demande

## Description

### DOMAINE DE L'INVENTION

La présente invention concerne un dispositif électronique comprenant des connexions électriques réalisées à l'aide de nanotubes de carbone (CNT) comme revendiquée dans la revendication 1. Elle porte également sur des procédés d'élaboration de telles connexions comme revendiquée dans la revendication 6.

Cette invention présente des applications notamment pour les connectiques thermiques, électriques et mécaniques.

### ETAT ANTERIEUR DE LA TECHNIQUE

L'utilisation de nanotubes de carbone (CNT) ou de faisceaux de CNT pour fabriquer des via traversants ou des interconnexions de puces a déjà été proposée, notamment dans le but de fournir un complément, voire une alternative à l'utilisation du cuivre. En effet, ce dernier n'est pas adapté lorsque les dimensions deviennent infimes. Les CNT possèdent en outre les propriétés nécessaires, comme une résistance électrique faible, qui permettent d'assurer au mieux la conductivité électrique entre les différents niveaux de puces.

Le via est une cavité permettant d'établir une connexion entre des plaques conductrices. Les lignes électriques réalisées sur les plaques établissent la connexion entre via. Les plaques conductrices sont réalisées en métal, tel que l'aluminium, et sont séparées par une couche isolante dans laquelle est creusée la cavité formant le via.

La miniaturisation des dispositifs électroniques rend l'utilisation de cuivre assez problématique car le cuivre cause des difficultés inhérentes à l'électromigration lorsque les densités de courant deviennent trop importantes. Les architectures faites de lignes et via en cuivre montrent donc leurs limites dans les circuits intégrés dont la résolution approche 22 nanomètres.

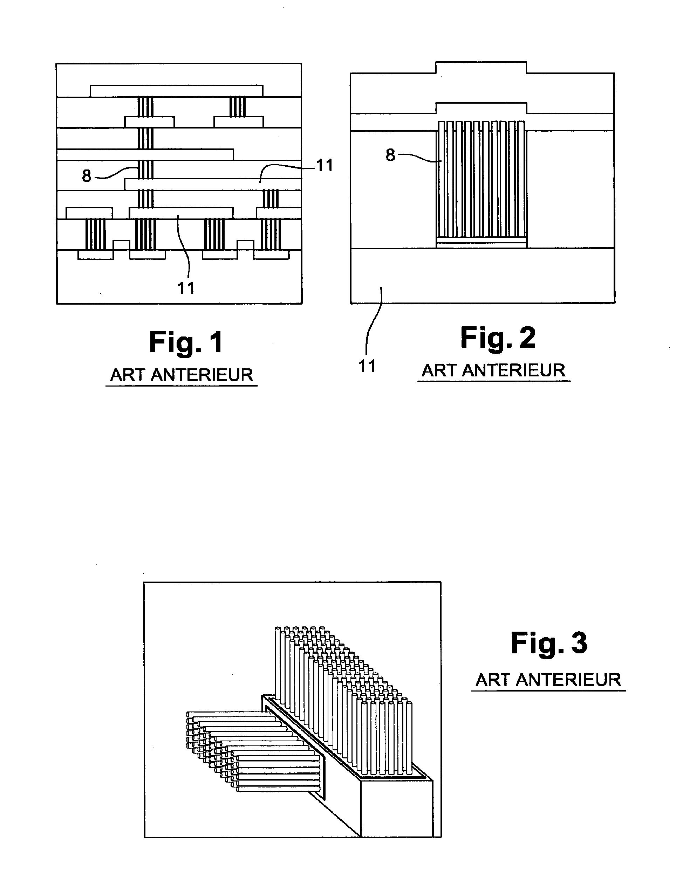

Comme illustré aux figures 1 et 2, il a été proposé l'utilisation de CNT pour assurer la connexion entre plaques conductrices, en remplaçant les via en cuivre ou tungstène par des CNT (Katagiri et al., Interconnect Technology Conference, 2009. IEEE International 1-3 June 2009, pp 44- 46 ; Yokoyama et al. Japanese Journal of Applied Physics, Vol. 47, No 4, 2008, pp 1985-1990). Cependant, cette méthode ne permet pas de s'affranchir totalement du cuivre, la connexion entre les via étant toujours assurée par une ligne en cuivre. Les problèmes liés à l'électromigration ne sont donc pas totalement supprimés ainsi.

Le document US 2008/0042287 décrit un dispositif électronique dans lequel les connexions sont assurées au moins partiellement par des faisceaux de CNT. Le via est recouvert d'une couche de matériau conducteur sur laquelle un autre faisceau de CNT peut être déposé et dirigé selon la direction de la ligne. Cependant, les via et les lignes ne sont pas formés à partir du même faisceau de CNT.

Le document US 2006/0212974 divulgue un dispositif électronique comprenant des faisceaux de CNT préparés à l'intérieur de via, et ensuite redirigés selon une autre direction de manière à relier deux couches conductrices de deux niveaux différents. Il ne s'agit pas de connexions entre via.

Le document CN 101562148 concerne un procédé pour élaborer des connexions verticales en CNT par dépôt d'une solution de CNT sur une couche conductrice. Dans ce dispositif, deux couches conductrices de niveaux différents sont reliées à l'aide de faisceaux de CNT.

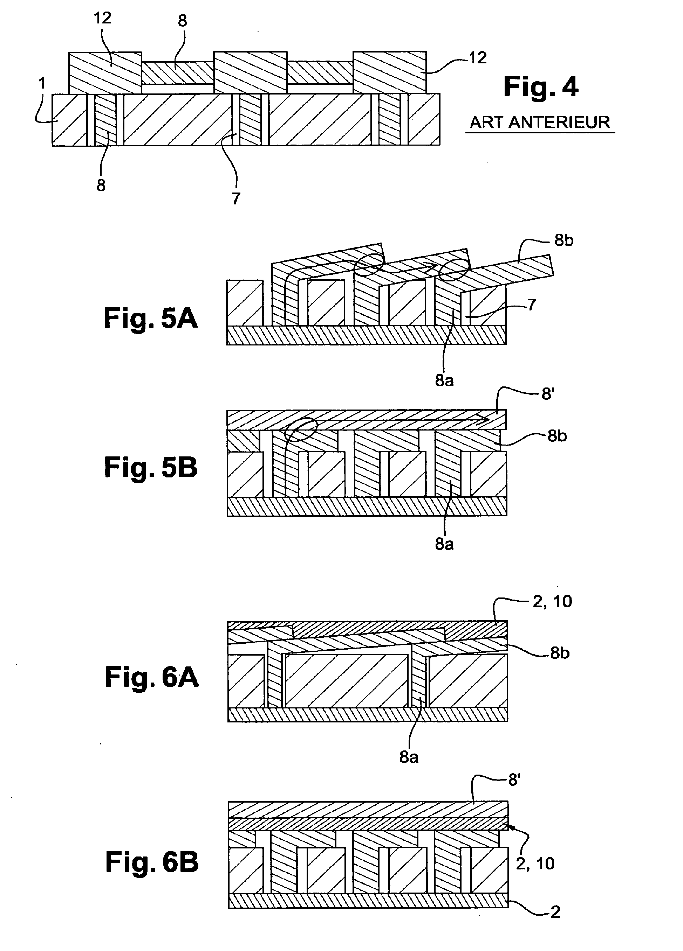

Une autre technologie repose sur le même concept de via en CNT mais elle consiste à utiliser des blocs métalliques pour changer l'orientation des CNT et former ainsi les lignes horizontales (Figure 3). Néanmoins, il est techniquement difficile de maîtriser le dépôt d'un catalyseur ainsi que la croissance de CNT selon deux directions perpendiculaires sur deux faces d'un bloc métallique (Figure 4). Un autre inconvénient lié à cette technique réside dans le passage répété par de nombreuses interfaces CNT - métal pour assurer la conduction.

Le document US 2009/0294966 décrit des via verticaux en CNT assurant la connexion électrique entre deux couches conductrices, mais aussi des lignes horizontales en CNT permettant la connexion électrique entre via. Il s'agit de deux faisceaux distincts dirigés selon deux directions différentes. Les faisceaux de CNT issus du via ne permettent pas de former la ligne.

Ces différentes approches impliquent la maîtrise de la croissance de CNT à l'intérieur de cavités de plus en plus petites, soulevant ainsi la problématique de la densité du faisceau de CNT. En effet, au même titre que l'homogénéité de leurs propriétés et de leur orientation, le contrôle de la densité des CNT est primordial pour assurer de bonnes connexions électriques dans le domaine de la nanoélectronique. Il est donc indispensable d'obtenir des densités de CNT fortes.

L'équipe de Hata (Hayamizu et al., Nature nanotechnology, Vol. 3, 2008, 289-294) a récemment démontré un effet organisateur et densificateur pouvant être obtenu par passage d'un film de CNT éparses dans une solution d'alcool. En effet, lorsque le film de CNT est plongé dans le bain d'alcool, perpendiculairement à la surface de ce dernier, puis séché, les CNT se regroupent et s'alignent. La tension de surface du liquide et les fortes interactions de Van der Waals rapprochent les CNT vers une structure proche de celle du graphite. Aucun désassemblage des CNT n'a été observé après densification. Cependant, Hata n'obtient que des structures composées de CNT dirigés selon la même direction limitant ainsi les applications envisageables.

La- présente invention s'inscrit dans la recherche de solutions techniques permettant notamment de s'affranchir de l'utilisation de métaux et mettant en oeuvre des procédés d'élaboration peu complexes.

### EXPOSE DE L'INVENTION

Ainsi, la présente invention offre une nouvelle architecture, permettant de s'affranchir de l'utilisation de métaux pour assurer la connectique entre plaques ou pour assurer le changement de direction d'un faisceau de CNT, qui repose sur la croissance et la redirection de nanotubes de carbone (CNT).

De manière générale, la présente invention consiste à assurer les connexions électriques, dans un dispositif électronique, par des faisceaux de nanotubes de carbone (CNT) dirigés selon une première direction et contenus dans des cavités appelées via. Ces faisceaux de CNT sont connectés latéralement entre eux par des lignes elles aussi constituées de faisceaux de CNT selon une deuxième direction.

Dans la suite de l'exposé, les termes « via » et « ligne » sont utilisés pour désigner les faisceaux de CNT contenus dans les cavités ou via et représentant les lignes de connexion, respectivement.

Typiquement, un dispositif électronique selon l'invention comporte un enchainement de structures faites notamment d'une plaque conductrice (par exemple en aluminium) recouverte d'une couche d'isolant (silice ou matériau low K de la microélectronique). Des cavités reliées entre elles par des lignes sont creusées dans le bloc isolant pour créer des interconnexions entre plaques (via) ou entre via (lignes).

Plus précisément, l'invention concerne un dispositif électronique comprenant des connexions électriques s'étendant selon au moins deux directions distinctes. De manière caractéristique, lesdites connexions sont essentiellement réalisées à l'aide de faisceaux de nanotubes de carbone (CNT), et dont au moins deux faisceaux de CNT comportent une partie, dont l'axe est dirigé selon une première direction, et une partie, dont l'axe est redirigé selon une deuxième direction. Par ailleurs, la connexion entre les faisceaux de CNT est assurée par tuilage des parties desdits au moins deux faisceaux de CNT de manière à former une ligne de connexion.

Ainsi, au moins deux faisceaux constituant les connexions électriques sont coudés, une zone de ces faisceaux de CNT étant dirigée selon la première direction et une autre zone selon une deuxième direction distincte.

Il est à noter que le système de connexions électriques faisant l'objet de l'invention permet la réalisation de connexions dans au moins deux directions, avantageusement verticale et horizontale, mais peut également servir à l'établissement de connexions dans plus de deux directions, notamment trois, en particulier dans le cas de deux connexions distinctes dans le plan horizontal.

Selon l'invention, les connexions électriques sont essentiellement réalisées à l'aide de faisceaux ou fagots de CNT, c'est-à-dire une multitude de nanotubes de carbone présentant un axe de croissance sensiblement parallèle et regroupés. Le terme « essentiellement » indique que les connexions électriques peuvent être assurées uniquement par les CNT, et donc en l'absence de lignes ou de blocs métalliques comme c'était le cas dans l'art antérieur. Toutefois et comme il sera décrit ci-dessous, le contact électrique entre les faisceaux peut être amélioré en réalisant en outre un dépôt métallique.

En pratique, de telles connexions électriques sont établies grâce à la mise en oeuvre du procédé suivant :
- croissance d'au moins un faisceau de CNT selon la première direction ;
- redirection d'une partie du faisceau de CNT selon la deuxième direction, avantageusement par passage d'un flux de liquide.

Typiquement, le procédé d'élaboration des connexions électriques dans au moins deux directions au sein d'un dispositif électronique selon l'invention comprend les étapes suivantes :
- croissance d'au moins deux faisceaux de CNT selon une première direction dans une cavité dudit dispositif ;
- redirection d'une partie desdits deux faisceaux de CNT selon une deuxième direction, avantageusement par passage d'un flux de liquide, de manière à former la ligne de connexion.

L'élaboration de ce dispositif comprend donc la croissance maitrisée de faisceaux de CNT selon une première direction au sein de cavités, suivant des techniques bien établies dans l'art antérieur, notamment à l'aide de catalyseurs tels que le fer.

Typiquement, la croissance des faisceaux de CNT est stoppée lorsque ces derniers ont une hauteur au moins supérieure à celle du via. Une partie de ces faisceaux de CNT est ensuite redirigée selon une deuxième direction, avantageusement par passage d'un flux de liquide.

La redirection du faisceau de CNT peut être assurée par la technique décrite dans le document Hayamizu et al. (Nature nanotechnology, Vol. 3, 2008, 289-294). En pratique, elle consiste à immerger les CNT dans une solution d'isopropanol et à les tirer parallèlement au sens d'une gorge, la gorge étant perpendiculaire au ménisque du liquide. Cette opération permet aussi de densifier les faisceaux de CNT.

Selon un mode de réalisation privilégié, la partie du faisceau de CNT ayant été redirigée selon la deuxième direction est sensiblement perpendiculaire à la partie du faisceau de CNT selon la première direction.

Typiquement, la première direction est sensiblement verticale. Avantageusement, la partie du faisceau de CNT selon la première direction forme le via du dispositif électronique.

De manière préférentielle, la deuxième direction est sensiblement horizontale. Avantageusement, la partie du faisceau de CNT selon la deuxième direction forme la ligne de connexion du dispositif électronique.

Dans un mode de réalisation privilégié, via et lignes sont donc sensiblement perpendiculaires.

De manière notamment à réaliser des connexions entre via, le dispositif électronique selon l'invention comprend préférentiellement au moins deux faisceaux de CNT dont les parties selon la deuxième direction, pouvant être sensiblement horizontale, forment la ligne de connexion. La ligne est avantageusement réalisée par tuilage des parties des faisceaux de CNT selon la deuxième direction, c'est-à-dire par superposition successive des extrémités des faisceaux.

Ce mode de réalisation est mis en oeuvre grâce au procédé suivant :
- croissance d'une pluralité de faisceaux parallèles de CNT selon la première direction, avantageusement à l'intérieur de via ;
- redirection d'une partie des faisceaux de CNT selon la deuxième direction ;
- connexion, avantageusement par tuilage, des parties des faisceaux de CNT selon la deuxième direction, de manière à réaliser la ligne de connexion.

Le tuilage est en fait obtenu par couchage de la partie supérieure des faisceaux de CNT ne laissant que la partie du faisceau de CNT contenue dans la cavité dans la première direction, de manière privilégiée sensiblement verticale. Avantageusement, la deuxième direction, celle du tuilage, est celle d'une gorge préalablement creusée dans le bloc isolant pour contenir la ligne de connexion.

Selon une mise en oeuvre particulière, le dispositif selon l'invention comporte en outre une couche métallique. Avantageusement, celle-ci recouvre au moins la partie des faisceaux de CNT selon la deuxième direction, et encore plus avantageusement recouvre la ligne de connexion.

Cette couche métallique peut permettre :
- d'uniformiser la surface du dispositif en vue d'une encapsulation ou pour servir de support pour élaborer un niveau supérieur de connexion. Dans ce dernier cas, il est judicieux de déposer un matériau métallique, par exemple de l'aluminium, apte à favoriser la croissance d'un deuxième niveau de CNT ; et/ou
- favoriser la connexion entre les via.

Cette couche métallique est déposée à l'aide de toute technique adaptée, connue de l'homme du métier.

Selon un autre mode de réalisation, le dispositif électronique peut en outre comprendre un autre faisceau de CNT connecté latéralement à au moins un faisceau de CNT du dispositif, au niveau de sa partie selon la deuxième direction, pour former la ligne. Cet autre faisceau de CNT assure la connexion avec un faisceau issu d'un via et éventuellement entre plusieurs via. La connexion est assurée après croissance de cet autre faisceau de CNT soit directement selon la deuxième direction, soit après sa redirection selon la deuxième direction comme décrit précédemment.

De manière préférentielle, l'autre faisceau de CNT est connecté latéralement à au moins deux faisceaux de CNT pour assurer la connexion entre les via.

Selon le mode opératoire choisi, les croissances de faisceaux de CNT formant soit les via, soit les lignes de connexion, peuvent être simultanées ou séparées.

Avantageusement, la croissance de l'autre faisceau de CNT n'est pas réalisée à l'intérieur d'une cavité mais au sein d'une gorge. L'autre faisceau de CNT ne peut donc pas entrer directement en contact avec la plaque conductrice, étant matériellement séparé par le bloc isolant. La redirection de cet autre faisceau de CNT selon la deuxième direction est éventuellement effectuée dans la gorge.

Dans ce mode de réalisation particulier, la connexion latérale entre les faisceaux de CNT est avantageusement assurée par le dépôt d'une couche métallique. En pratique, elle est située à l'interface des deux types de faisceaux de CNT : au moins un faisceau de CNT, au niveau de sa partie selon la deuxième direction, issu du ou des via et l'autre faisceau formant la ligne. Cette couche est avantageusement réalisée à l'aide d'un métal dit de contact choisi dans le groupe suivant : palladium, cuivre, or ou titane. Ainsi, le métal de contact assure la connexion entre les faisceaux de CNT issus des via et le faisceau de CNT formant la ligne de connexion.

Dans le cadre de l'invention, afin de localiser les CNT dans des zones de croissance prédéterminées, on peut :
- soit déposer le catalyseur de croissance sur toute la plaque puis l'éliminer (par gravure, polissage, ...) dans les zones non prédéterminées ;
- ou bien déposer du TiN sur les zones non prédéterminées, puis déposer le catalyseur pleine plaque, comme décrit dans Dijon et al. (Diam. Relat. Mater., 2009, doi :10.1016/j.diamond.2009.11.017).

Selon un mode de réalisation préféré, le procédé d'élaboration des connexions électriques dans au moins deux directions au sein d'un dispositif électronique selon l'invention, comprend en outre une étape de dépôt d'au moins une couche métallique sur la partie des faisceaux de CNT selon la deuxième direction.

Il peut également comprendre une étape de croissance, et éventuellement de redirection selon la deuxième direction, d'un autre faisceau de CNT destiné à connecter latéralement au moins un faisceau de CNT, au niveau de sa partie selon la deuxième direction, pour former la ligne de connexion. Dans ce cas particulier, le procédé peut éventuellement comprendre une étape de dépôt d'une couche métallique sur l'autre faisceau de CNT.

Par ailleurs, le procédé d'élaboration du dispositif selon l'invention peut comprendre au moins une étape de dépôt de TiN sur les zones où les CNT ne doivent pas croître.

Il ressort que dans les dispositifs électroniques selon l'invention, le courant électrique passe essentiellement par les nanotubes de carbone, réduisant considérablement les problèmes d'électromigration. En outre, les procédés d'élaboration de tels dispositifs mettent en oeuvre des techniques relativement maîtrisées.

### EXEMPLES DE REALISATION DE L'INVENTION

La manière dont l'invention peut être réalisée et les avantages qui en découlent, ressortiront mieux des exemples de réalisation qui suivent, donnés à titre indicatif et non limitatif, à l'appui des figures annexées.
La figure 1 représente un schéma illustrant l'intégration de nanotubes de carbone (CNT) dans des interconnexions ULSI (« Ultra Large Scale Intégration ») selon l'art antérieur.
La figure 2 est un schéma illustrant l'art antérieur, à savoir la croissance de nanotubes de carbone (CNT) dans des via, établissant un contact avec les câbles de cuivre.
La figure 3 est une vue tridimensionnelle et en microscopie d'un système d'interconnexion ligne/via selon l'art antérieur, impliquant un bloc de contact métallique.
La figure 4 est un schéma d'un système d'interconnexion ligne/via selon l'art antérieur, impliquant un bloc de contact métallique.
La figure 5 est un schéma du dispositif d'interconnexion selon l'invention, par tuilage de CNT redirigés issus de via (A) ou par connexion entre des CNT distincts (B), respectivement. La flèche indique la circulation du courant et les cercles les interfaces à franchir.
La figure 6 est un schéma de deux dispositifs d'interconnexion selon l'invention (A, B), dans lesquels le contact entre les faisceaux de CNT est amélioré au moyen d'un métal.
La figure 7 est un schéma de principe d'un mode de réalisation de l'invention selon lequel les via et les lignes sont réalisés simultanément. Vues de gauche : vues en coupe ; vues de droite : vues de dessus.
La figure 8 est un schéma illustrant un procédé d'élaboration d'un dispositif d'interconnexion selon l'invention par tuilage des CNT : A/ à F/ : vues en bout, perpendiculaires à la gorge ; G/ et H/ : vues parallèles au sens de la gorge.
La figure 9 est un schéma illustrant un procédé d'élaboration d'un dispositif d'interconnexion alternatif de l'invention, par croissance simultanée des via et de la ligne.
La figure 10 est un schéma illustrant un procédé d'élaboration d'un dispositif d'interconnexion alternatif de l'invention, par croissance indépendante des via et de la ligne, et insertion d'un métal de contact.

### DESCRIPTION DETAILLEE DE L'INVENTION

Les différents modes de réalisation décrits ci-dessous se rapportent à un dispositif électronique nécessitant des interconnexions à la fois verticales et horizontales, et donc dans deux directions distinctes perpendiculaires. L'ensemble de ces connexions est réalisé à l'aide de nanotubes de carbone (CNT) :
- les connexions verticales sont formées par des faisceaux verticaux de CNT qui croissent à l'intérieur de via, aménagés dans une couche de matière isolante ;
- les connexions horizontales sont également assurées par des CNT et forment les lignes de connexion. Elles peuvent résulter du tuilage des faisceaux issus des via, redirigés (premier mode de réalisation ; Fig 5A) ou être issues de la croissance d'un faisceau indépendant en contact latéral avec les faisceaux issus des via, redirigés (second mode de réalisation ; Fig 5B).

Selon une mise en oeuvre particulière, une couche métallique **2, 10** est également en contact avec les faisceaux de CNT, notamment sur les portions **8b** des faisceaux de CNT (Fig. 6A et Fig. 6B).

Une telle couche peut avantageusement être constituée de :
- une couche **10,** par exemple en Pd ou Ti, améliorant le contact des CNT ; et/ou
- une couche **2,** par exemple en Al, permettant la croissance d'un nouveau niveau de CNT et donc d'interconnexion.

Alternativement, il peut s'agir d'une bicouche associant les deux types de couches **10** et 2.

### I/ PREMIER MODE DE REALISATION DE L'INVENTION:

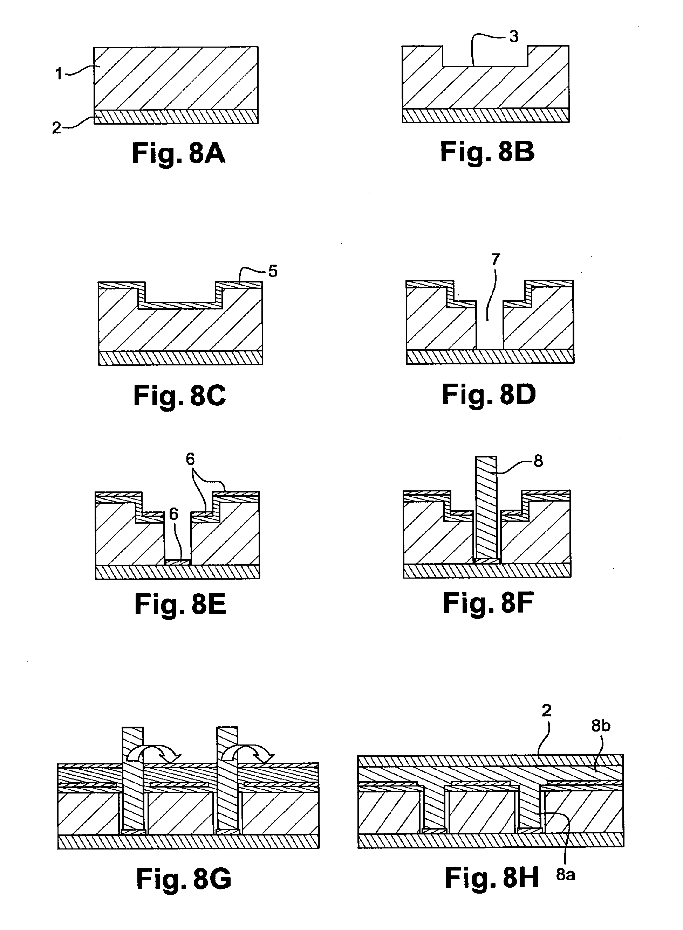

Comme déjà dit, ce premier mode de réalisation par tuilage des faisceaux de CNT verticaux est illustré aux figures 5A et 6A, respectivement.
Plus précisément, son procédé d'élaboration est illustré à la figure 8. A noter que les étapes A à F sont schématisées à l'aide de vues en bout, c'est-à-dire perpendiculaires à la gorge **3,** les figures 8G et 8H correspondent à des vues parallèles au sens de la gorge **3.**

### A/ Elaboration de la structure de base :

Une couche isolante **1,** en silice ou en matériaux low K de la microélectronique, est déposée sur la couche conductrice **2.** Le conducteur **2** est typiquement de l'aluminium.

### B/ Gravure de la gorge :

On réalise au sein de l'isolant **1** la gorge **3** qui deviendra la future ligne **4,** par des procédés de lithographie conventionnels.

### C/ Dépôt de TiN :

Une couche de TiN **5,** d'environ 50 nanomètres d'épaisseur, est déposée dans la gorge **3,** si possible au moyen d'une méthode de dépôt conforme. Le TiN a pour fonction d'inhiber la croissance des nanotubes de carbone lorsque le catalyseur **6,** en l'occurrence le fer, est déposé sur le TiN.

### D/ Ouverture des via :

Des via **7** sont ouverts dans la gorge **3,** la gravure à travers l'isolant **1** s'arrêtant sur le conducteur **2.**

### E/ Dépôt du catalyseur :

Le dépôt du catalyseur **6** est réalisé à température ambiante. Il s'agit typiquement d'une couche de 1 nanomètre de fer, déposée par évaporation ou par « Ion Beam Sputtering ». Le dépôt se fait en incidence normale, pour minimiser la couverture des flancs.

### F/ Croissance sélective des nanotubes :

De manière classique, on fait pousser les nanotubes de carbone (CNT) **8** à 600°C, au moyen d'un mélange C₂H₂+H₂+He (10sccm, 50sccm, 50sccm), après avoir préalablement oxydé le fer au moyen d'un plasma RF d'air réalisé à température ambiante. Les conditions du plasma sont les suivantes :
- P=0.3Torr;
- Puissance 70W pendant 30 minutes.

Ce procédé permet la croissance des nanotubes **8** sur le fer **6,** sauf si ce dernier est déposé sur du TiN **5.** Dans ce cas, il n'y a pas de croissance.

La pression lors de la croissance à 600°C est de 1 Torr. Les gaz réactifs sont introduits après le plasma à froid et la montée en température se fait en 15 minutes avec une pression de 0.3 Torr.

La hauteur des nanotubes **8** est réglée par le temps de croissance.

### G/ Redirection des nanotubes :

Après croissance, le dispositif est immergé dans de l'alcool isopropylique et tiré perpendiculairement au sens de la gorge **3** : le ménisque du liquide est perpendiculaire à la gorge **3.** Le liquide circulant dans la gorge couche les tubes **8** provenant des via **7.** Les tubes sont fortement densifiés après cette opération. En outre, les tubes **8** présentent deux parties distinctes :
- une partie **8a,** dont l'axe est parallèle à celui des via **7,** et
- une partie **8b** dont l'axe est parallèle à celui de la gorge **3.**

Les faisceaux de nanotubes **8,** issus des différents via **7,** sont ainsi couchés dans la gorge **3** et entrent en contact. Il est donc possible de réaliser une connexion ligne **4** par tuilage d'au moins deux faisceaux de nanotubes en provenance de différents via 7.

A l'issue de cette étape, on obtient un système d'interconnexion tel qu'illustré à la figure 5A. La ligne **4** est réalisée par tuilage des faisceaux de nanotubes **8b** issus des via **7.** Dans ce mode de réalisation, la résistance de la ligne R est composée d'une série de résistances d'interfaces ajoutée à la résistance des nanotubes.

Toutefois, dans une étape ultérieure (Fig. 8H), il peut être recommandé de réaliser un dépôt métallique **2,** à nouveau en aluminium, à la surface de la ligne **4** de manière à planariser la structure et à pouvoir recommencer l'opération (création d'interconnexions) au niveau suivant (encapsulation). A l'issue de cette étape, on obtient un système d'interconnexion tel qu'illustré à la figure 6A.

### II/ SECOND MODE DE REALISATION DE L'INVENTION :

Ce second mode de réalisation est illustré à la fois aux figures 5B, 6B, 7, 9 et 10.

La figure 5B illustre le fait que la résistance de la ligne est plus faible que dans le premier mode de réalisation car il n'y a plus qu'une seule résistance d'interface.

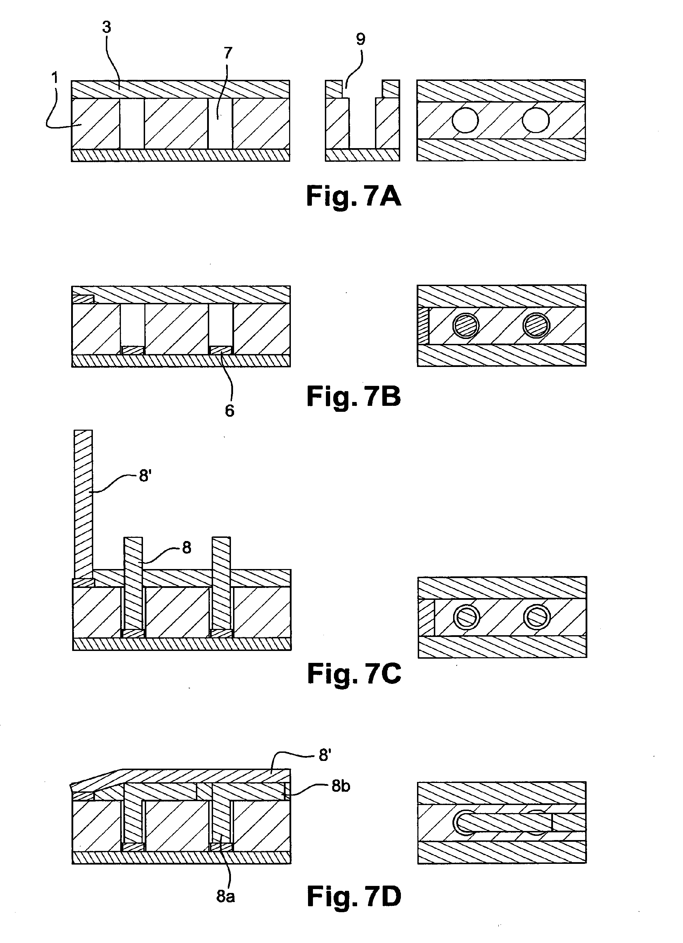

La figure 7 est une figure illustrant le principe de ce second mode de réalisation selon lequel les interconnexions sensiblement perpendiculaires, via **7** et lignes **4** respectivement, sont issues d'au moins deux faisceaux distincts de nanotubes, avantageusement réalisés de manière simultanée. A noter que les schémas de la partie gauche représentent des vues en coupe, alors que ceux de la partie droite sont des vues de dessus.

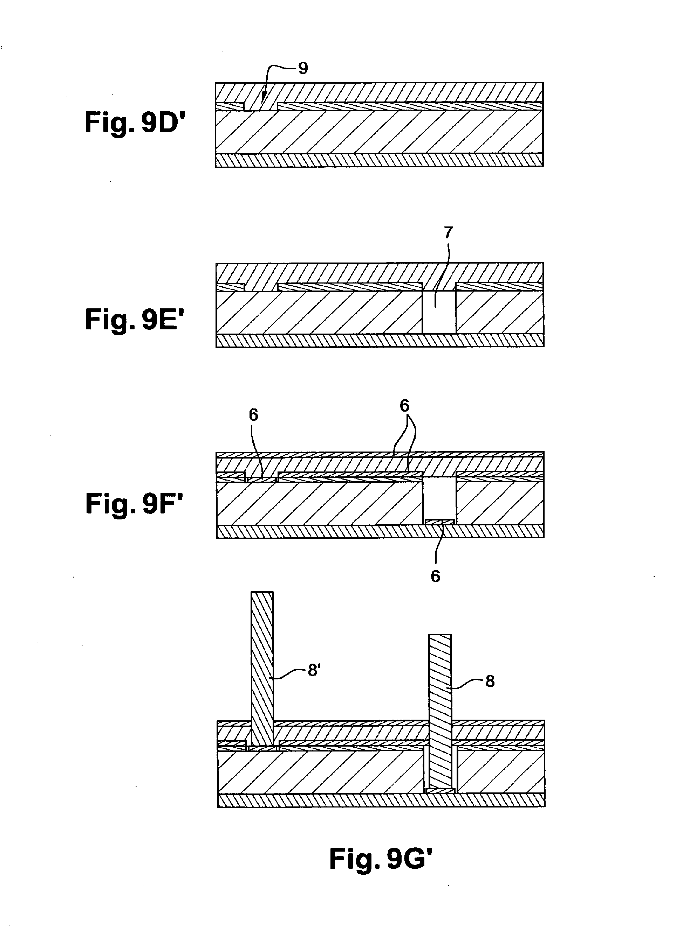

Par ailleurs, le mode de réalisation impliquant la croissance simultanée des nanotubes 8 **et 8'** à partir de la ligne **4** et des via 7 est illustré à la figure 9, qui dérive de la figure 8.

Les étapes A à C sont similaires à celles de la figure 8.

En revanche, avant l'ouverture des via **7,** une étape supplémentaire est réalisée (Fig. 9D') : une ouverture **9** du TiN **5** est aménagée dans la gorge **3,** de façon à obtenir la croissance de nanotubes de carbone **8'** dans cette zone, après dépôt du catalyseur **6.** Ceci correspond à l'aménagement de la zone de croissance **9** de la ligne.

L'étape suivante consiste à réaliser l'ouverture des via **7** après avoir protégé les ouvertures **9** par une couche de résine (Fig. 9E').

Après dépôt du catalyseur **6** (Fig. 9F') et lors de l'étape de croissance (Fig. 9G'), les tubes **8** et **8'** poussent dans les via **7** et dans la zone de croissance **9** ménagée au niveau de la ligne, respectivement. La longueur des faisceaux issus de CNT **8** et **8'** peut être différente, en jouant sur l'épaisseur du catalyseur et sur les conditions plasma différentes dans les via et sur la ligne.

Après redirection des deux faisceaux de nanotubes (**8, 8'**) issus des via **7** et de la zone de croissance **9,** respectivement, le système d'interconnexion obtenu correspond à celui illustré à la figure 5B. On constate que la ligne **4** de connexion est réalisée au moyen d'un faisceau de nanotubes **8'** ne provenant pas des via **7.**

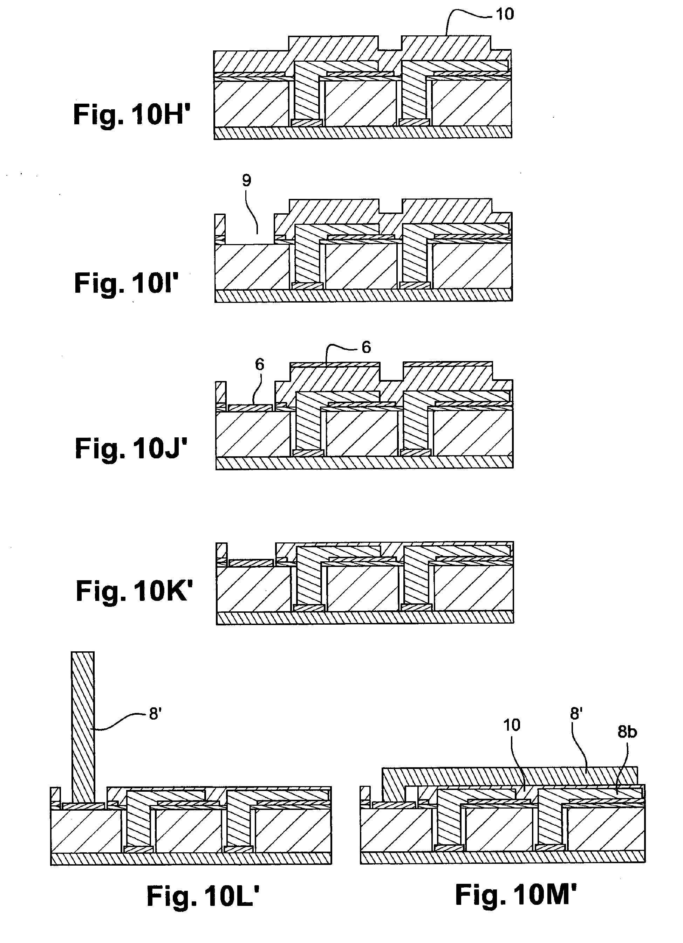

Quant à la figure 10, elle dérive de la figure 8, mais dans un mode de réalisation où la croissance des nanotubes **8** et **8'** est réalisée séparément à partir de la ligne **4** et des via 7, et où un métal d'interface **10** est inséré entre les deux faisceaux de nanotubes (entre les CNT des via **8b** et les CNT des lignes **8',** respectivement).

Le procédé débute comme aux étapes A à G de la figure 8.

En revanche en lieu et place de l'étape H, ce sont les étapes H' à M' de la figure 10 qui sont mises en oeuvre :

### H'/ Dépôt d'un métal de contact :

Après redirection des nanotubes **8** issus des via **7** (**8a, 8b**), on dépose le métal de contact **10,** tel que du palladium, du cuivre, de l'or ou du titane.

### I'/ Ouverture métal de contact :

On ouvre alors le métal de contact **10** en bout de la gorge **3,** jusqu'à l'isolant **1** par gravure. On forme ainsi la zone de croissance **9** des futurs nanotubes **8'** issus de la ligne **4.**

### J'/ Dépôt du catalyseur :

On dépose le catalyseur par évaporation ou pulvérisation.

### K'/ Planarisation du métal de contact :

On planarise le dispositif par CMP (« *Chemical and Mechanical Polishing* ») de façon à supprimer le dépôt de catalyseur **6** sur le métal de contact **10,** tout en conservant le catalyseur **6** dans la zone de croissance **9.**

### L'/ Deuxième croissance de nanotubes :

On réalise une deuxième croissance dans les mêmes conditions qu'à l'étape F de la figure 8. On obtient ainsi le faisceau de nanotubes **8'** issus de la zone de croissance **9** et destinés à former la ligne **4.**

### M'/ Redirection de la ligne :

Après croissance, le faisceau de nanotubes est redirigé de manière similaire à l'étape G de la figure 8. On obtient ainsi une ligne de connexion **4** en contact via le métal **10** avec les nanotubes **8** issus du via **7.**

A l'issue d'un tel procédé, on obtient un système d'interconnexion tel qu'illustré à la figure 6B.

## Revendications

1. Dispositif électronique comprenant des connexions électriques s'étendant selon au moins deux directions distinctes, lesdites connexions étant réalisées à l'aide de faisceaux de nanotubes de carbone (CNT) (8) et dont au moins deux faisceaux de CNT comportent une partie (8a), dont l'axe est dirigé selon une première direction, et une partie (8b), dont l'axe est redirigé selon une deuxième direction, **caractérisé en ce que** la connexion entre les faisceaux de CNT étant assurée par superposition successive des extrémités desdits au moins deux faisceaux de manière à former une ligne de connexion (4), au moins un desdits faisceaux de CNT comportant une partie (8a) au sein d'un via.

2. Dispositif électronique selon la revendication 1, ***caractérisé* en ce que** les deux directions distinctes sont sensiblement perpendiculaires.

3. Dispositif électronique selon la revendication 1 ou 2, ***caractérisé* en ce que** la première direction est sensiblement verticale et **en ce que** la partie du faisceau de CNT (8a) selon cette direction forme un via (7).

4. Dispositif électronique selon l'une des revendications précédentes, ***caractérisé* en ce que** la deuxième direction est sensiblement horizontale et **en ce que** la partie du faisceau de CNT (8b) selon cette direction forme une ligne de connexion (4).

5. Dispositif électronique selon la revendication 4, ***caractérisé* en ce qu'**il comporte une couche métallique (10, 2) sur la ligne de connexion (4).

6. Procédé d'élaboration des connexions électriques dans au moins deux directions au sein d'un dispositif électronique comprenant des connexions électriques s'étendant selon au moins deux directions distinctes, lesdites connexions étant réalisées à l'aide de faisceaux de nanotubes de carbone (CNT) (8) et dont au moins deux faisceaux de CNT comportent une partie (8a), dont l'axe est dirigé selon une première direction, et une partie (8b), dont l'axe est redirigé selon une deuxième direction, la connexion entre les faisceaux de CNT étant assurée par superposition successive des extrémités desdits au moins deux faisceaux de manière à former une ligne de connexion (4), au moins un desdits faisceaux de CNT comportant une partie (8a) au sein d'un via ;
ledit procédé comprenant les étapes suivantes :
- croissance d'au moins deux faisceaux de CNT (8) selon une première direction (8a) dudit dispositif, la croissance d'au moins l'un des deux faisceaux de CNT étant réalisée au sein d'un via et à une hauteur supérieure à celle du via ;
- formation d'une ligne de connexion (4) par redirection d'une partie desdits deux faisceaux de CNT (8) selon une deuxième direction (8b), par passage d'un flux de liquide.

7. Procédé selon la revendication 6, ***caractérisé* en ce qu'**il comprend en outre la croissance d'au moins un faisceau de CNT (8') au sein d'une gorge.

8. Procédé selon la revendication 6, ***caractérisé* en ce qu'**il comprend en outre une étape de dépôt d'au moins une couche métallique (10, 2) sur la partie des faisceaux de CNT selon la deuxième direction (8b).

9. Procédé selon l'une des revendications 6 à 8, ***caractérisé* en ce qu'**il comprend en outre au moins une étape de dépôt de TiN sur les zones où les CNT ne doivent pas croître.

## Patentansprüche

1. Elektronische Vorrichtung, elektrische Verbindungen umfassend, die sich in mindestens zwei verschiedenen Richtungen erstrecken, wobei die Verbindungen mittels Bündeln aus Kohlenstoffnanoröhrchen (CNT) (8) hergestellt sind, und wovon mindestens zwei CNT-Bündel einen Teil (8a), dessen Achse in einer ersten Richtung ausgerichtet ist, und einen Teil (8b) umfassen, dessen Achse in einer zweiten Richtung umgelenkt ist, **dadurch gekennzeichnet, dass** die Verbindung zwischen den CNT-Bündeln durch ein aufeinanderfolgendes übereinander Anordnen der Enden der mindestens zwei Bündel sichergestellt ist, um eine Verbindungsleitung (4) zu bilden, wobei mindestens eines der CNT-Bündel einen Teil (8a) im Inneren eines Durchgangs umfasst.

2. Elektronische Vorrichtung nach Anspruch 1, **dadurch gekennzeichnet, dass** die zwei verschiedenen Richtungen im Wesentlichen senkrecht sind.

3. Elektronische Vorrichtung nach Anspruch 1 oder 2, **dadurch gekennzeichnet, dass** die erste Richtung im Wesentlichen vertikal ist, und dass der Teil (8a) des CNT-Bündels in dieser Richtung einen Durchgang (7) bildet.

4. Elektronische Vorrichtung nach einem der vorhergehenden Ansprüche, **dadurch gekennzeichnet, dass** die zweite Richtung im Wesentlichen horizontal ist, und dass der Teil (8b) des CNT-Bündels in dieser Richtung eine Verbindungsleitung (4) bildet.

5. Elektronische Vorrichtung nach Anspruch 4, **dadurch gekennzeichnet, dass** sie eine Metallschicht (10, 2) auf der Verbindungsleitung (4) umfasst.

6. Verfahren zum Erstellen elektrischer Verbindungen in mindestens zwei Rich-tungen im Inneren einer elektronischen Vorrichtung, die elektrische Verbindungen umfasst, die sich in mindestens zwei verschiedenen Richtungen erstrecken, wobei die Verbindungen mittels Bündel aus Kohlenstoffnanoröhrchen (CNT) (8) hergestellt sind, und wovon mindestens zwei CNT-Bündel einen Teil (8a), dessen Achse in einer ersten Richtung ausgerichtet ist, und einen Teil (8b) umfassen, dessen Achse in einer zweiten Richtung umgelenkt ist, wobei die Verbindung zwischen den CNT-Bündeln durch ein aufeinanderfolgendes übereinander Anordnen der Enden der mindestens zwei Bündel sichergestellt ist, um eine Verbindungsleitung (4) zu bilden, wobei mindestens eines der CNT-Bündel einen Teil (8a) im Inneren eines Durchgangs umfasst;
wobei das Verfahren die folgenden Schritte umfasst:
- Aufwachsenlassen von mindestens zwei CNT-Bündeln (8) in einer ersten Richtung (8a) der Vorrichtung, wobei das Wachstum mindestens eines der zwei CNT-Bündel im Inneren eines Durchgangs und bis auf eine Höhe erfolgt, die größer ist als diejenige des Durchgangs;
- Ausbilden einer Verbindungsleitung (4), indem ein Teil der zwei CNT-Bündel (8) mittels Durchleitens einer Flüssigkeitsströmung in eine zweite Richtung (8b) umgelenkt wird.

7. Verfahren nach Anspruch 6, **dadurch gekennzeichnet, dass** es darüber hinaus das Aufwachsen mindestens eines CNT-Bündels (8') im Inneren einer Ausnehmung umfasst.

8. Verfahren nach Anspruch 6, **dadurch gekennzeichnet, dass** es darüber hinaus einen Schritt des Abscheidens mindestens einer Metallschicht (10, 2) auf dem Teil (8b) der CNT-Bündel in der zweiten Richtung umfasst.

9. Verfahren nach einem der Ansprüche 6 bis 8, **dadurch gekennzeichnet, dass** es darüber hinaus mindestens einen Schritt des Abscheidens von TiN auf den Zonen umfasst, auf denen die CNT nicht aufwachsen sollen.

## Claims

1. An electronic device comprising electric connections extending along at least two different directions, said connections being essentially formed by means of carbon nanotubes (CNT) (8), where at least two CNT bundles comprise a portion (8a) having its axis directed along a first direction and a portion (8b) having its axis redirected along a second direction, **characterized in that** the connection between CNT bundles is achieved by successive overlapping of the ends of said at least two bundles to form a connection line (4), at least one of said CNT bundles having a portion (8a) within a via.

2. The electronic device of claim 1, **characterized in that** the two different directions are substantially perpendicular.

3. The electronic device of claim 1 or 2, **characterized in that** the first direction is substantially vertical and **in that** the portion of the CNT bundle (8a) along this direction forms a via (7).

4. The electronic device of any of the foregoing claims, **characterized in that** the second direction is substantially horizontal and **in that** the portion of the CNT bundle (8b) along this direction forms a connection line (4).

5. The electronic device of claim 4, **characterized in that** it comprises a metal layer (10, 2) on the connection line (4).

6. A method for creating electric connections in at least two directions within an electronic device comprising electric connections extending along at least two different directions, said connections being made of carbon nanotubes (CNT) bundles (8), where at least two CNT bundles comprise a portion (8a) having its axis directed along a first direction and a portion (8b) having its axis redirected along a second direction, the connection between CNT bundles being achieved by successive overlapping of the ends of said at least two bundles to form a connection line (4), at least one of said CNT bundles having a portion (8a) within a via, said method comprising the steps of:
- growing at least two CNT bundles (8) along a first direction (8a) of said device; the growth of at least one of said CNT bundles being achieved in a via and to a height superior to the height of said via;
- forming a connection line (4) by redirecting a portion of said two CNT bundles (8) along a second direction (8b) by flowing of a liquid.

7. The method of claim 6, **characterized in that** it further includes the growth of at least one CNT bundle (8) within a groove.

8. The method of claim 6, **characterized in that** it further comprises a step of deposition of at least one metal layer (10, 2) on the portion of the CNT bundles along the second direction (8b).

9. The method of any of claims 6 to 8, **characterized in that** it further comprises at least one step of deposition of TiN on areas where CNTs should not grow.
